# EUROPEAN PATENT SPECIFICATION

(11) **EP 0 594 117 B1**
(45) Date of publication and mention of the grant of the patent: **09.12.1998**
(21) Application number: 93116850.4
(22) Date of filing: 19.10.1993
(51) Int. Cl.: H03H 9/56, H03H 3/02

(54) **Piezoelectric filter and its production method**
Piezoelektrisches Filter und Verfahren zu seiner Herstellung
Filtre piezoélectrique et sa méthode de fabrication

(30) Priority: 20.10.1992 JP 281473/92; 20.10.1992 JP 281474/92
(43) Date of publication of application: 27.04.1994
(73) Proprietor: MATSUSHITA ELECTRIC INDUSTRIAL CO., LTD., Kadoma-shi, Osaka-fu, 571 (JP)
(72) Inventor: Taguchi, Yutaka, Settsu-shi, Osaka-fu 566 (JP); Eda, Kazuo, Nara-shi, Nara-ken 631 (JP); Kanaboshi, Akihiro, Neyagawa-shi, Osaka-fu 572 (JP); Ogura, Tetsuyoshi, Osaka-shi, Osaka-fu 532 (JP)
(74) Representative: Eisenführ, Speiser & Partner

(56) References cited:
- EP-A- 0 503 892
- US-A- 4 293 986
- 1990 ultrasonics symp. ; s.v. Krishnaswamy et al film bulk acoustic wave resonator technology; p529-536;

## Description

### BACKGROUND OF THE INVENTION

The present invention relates to a piezoelectric filter utilizing piezoelectric property of an oscillatory piezoelectric plate made of lithium tantalate, lithium niobate or lithium borate.

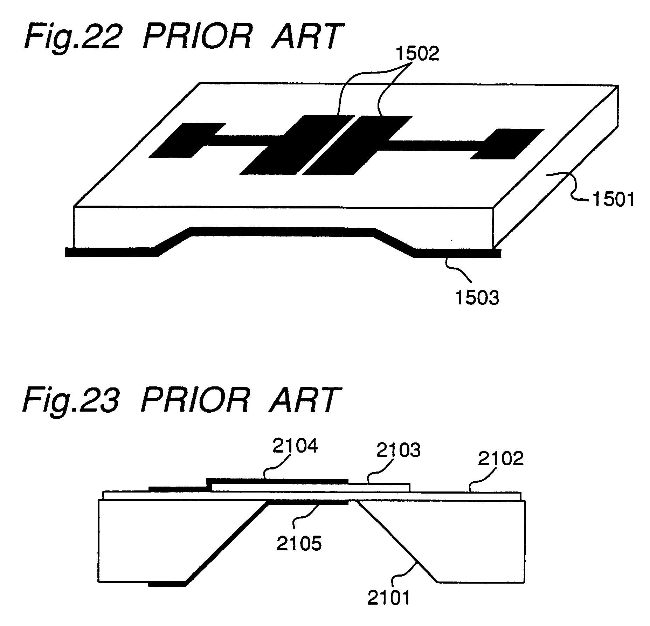

In response to development of mobile communications, there is demand for compact and light terminals including filters or the like. Conventionally, various filters have been used as a first intermediate frequency filter for mobile communications and mainly include a piezoelectric filter and an elastic surface wave filter. Generally, the piezoelectric filter has such a basic construction as shown in Fig. 22 and includes an oscillatory piezoelectric plate 1501, a pair of upper electrodes 1502 formed on an upper face of the piezoelectric plate 1501 and a lower electrode 1503 formed on a lower face of the piezoelectric plate 1501. The upper electrodes 1502 and the lower electrode 1503 on the single piezoelectric plate 1501 form two sets of counter electrodes. This known piezoelectric filter is a double mode monolithic piezoelectric filter based on a principle in which electric signals are converted into mechanical oscillations by one set of the counter electrodes and the mechanical oscillations are converted into the electric signals by the other set of the counter electrodes. Bandwidth obtained in such a filter depends upon piezoelectric constant of the piezoelectric plate 1501 and is about 0.2 % of that at a central frequency in fundamental mode when an AT-CUT quartz plate in ordinary use is employed. In the case of higher-order mode, i.e. overtone of n-th order, bandwidth is further narrowed to 1/(n²) of 0.2 %.

Meanwhile, in response to recent digitization of mobile communications, channel bands have been widened to about 300 KHz. Meanwhile, first intermediate frequency is raised to about 200 MHz by widening of the channel bands. In the known high-frequency piezoelectric filter, since overtone of higher order is employed, it is difficult to obtain a broad band. Consequently, generally, the elastic surface wave filter has been used for the broad-band first intermediate frequency filter. However, the elastic surface wave filter is neither satisfactory in both shape and weight nor is electrically sufficient due to insertion loss, etc. Meanwhile, in order to operate the electrically excellent piezoelectric filter in fundamental wave mode, the quartz plate should be made thin because the resonance frequency is inversely proportional to thickness of the quartz plate. When the AT-CUT quartz plate in ordinary use is oscillated at, for example, 100 MHz, the quartz plate should have a thickness of about 17 µm and thus, production of the quartz plate is extremely difficult. Furthermore, even if such a quartz plate is produced satisfactorily, handling for mounting the quartz plate and connection of the quartz plate to an external circuit are quite difficult due to small thickness of the quartz plate.

Therefore, for example, a method is also proposed by Japanese Patent Laid-Open Publication No. 3-235408 (1991) in which quartz of an oscillatory portion is made thin by etching so as to be capable of being used at high frequency. In this known method, only the oscillatory portion of the quartz plate having a thickness of about 70 µm is made thin to about 20 µm by etching such that high-frequency oscillation of the oscillatory portion is made possible. Since resonance frequency is controlled by etching, it will be extremely difficult due partly to etching accuracy to mass produce filters in which bandwidth is quite narrow and accuracy of central frequency is strict.

Meanwhile, in order to widen the band, electromechanical coupling coefficient of the piezoelectric substrate may be changed to a larger one. Nevertheless, since there is not much difference of velocity of sound therebetween, problem of thickness control is not solved yet.

A piezoelectric filter at high high frequency is disclosed in, for example, a paper entitled "Film Bulk Acoustic wave Resonator Technology" in 1990 Ultrasonic Symposium Proceedings, page 529 and U.S. Patent No. 4719383 entitled "Piezoelectric Shear Wave Resonator and Method of Making Same". In the known piezoelectric filter, a cushioning film 2102 of SiO₂ is formed on a substrate 2101 of silicon or gallium-arsenic as shown in Fig. 23. Furthermore, after a thin film 2103 of aluminum nitride or zinc oxide has been formed on the cushioning film 2102, electrodes 2104 and 2105 are formed. As a result, a resonator or a filter is obtained. However, in this technology, zinc oxide or aluminum nitride is used for the piezoelectric member. This piezoelectric member can be advantageously formed by sputtering, i.e. thin film forming technology. However, since the piezoelectric member is made of polycrystalline material, crystals should be aligned in C-axis in order to obtain piezoelectric property. Undesirably, this alignment largely depends upon thin film forming conditions or devices and changes according to thickness of the film deposited on the substrate or material of the ground. On the other hand, quartz, lithium niobate, lithium tantalate, lithium borate or the like in polycrystalline form does not exhibit sufficient piezoelectric property. Especially, quartz is widely used for an oscillator, a filter or the like due to its high stability and excellent temperature characteristics but only α quartz which is monocrystalline and has a crystalline structure symmetric with respect to a threefold axis exhibits piezoelectric property.

Meanwhile, a similar technology is disclosed in U.S. Patent No. 5036241 entitled "Piezoelectric Laminate and Method of Manufacture". In the known technology, substance having piezoelectric property is bonded to an insulating member by using an adhesive layer and resistivity of the insulating member is controlled by using temperature or light such that polarization is caused by applying voltage to the insulating member. According to this known method, since accuracy of the piezoelectric member in a direction of its thickness determines accuracy of resonance frequency in a device employing resonance in the direction of thickness of the piezoelectric member, thickness of the adhesive layer is required to be controlled accurately. However, in the case where the AT-CUT quartz substrate acts as the piezoelectric member and its central frequency is set to 100 MHz, the substrate has a thickness of 17 µm. In view of production cost of the piezoelectric filter from mass production efficiency and operation for adjustments, the piezoelectric member should have an accuracy of not more than 1 µm. Since error of thickness of the adhesive layer directly determines accuracy of frequency, it is considered impossible to attain such an accuracy of the piezoelectric member in this method and the arrangement.

Document EP 503, 892 discloses a high frequency filter formed by directly bonding a quartz crystal resonator to a semiconductor substrate.

### SUMMARY OF THE INVENTION

Accordingly, an essential object of the present invention is to provide a piezoelectric filter which can be used also in a superhigh frequency band and can be mass produced.

The invention is defined by the appended claims.

In order to accomplish this object of the present invention, a method of producing a piezoelectric substrate, according to the present invention comprises the steps of directly bonding a piezoelectric substrate to a substrate for holding the piezoelectric substrate, the piezoelectric substrate acting as an oscillator and being made of one of lithium tantalate, lithium niobate and lithium borate, while the substrate is made of one of quartz, lithium tantalate, lithium niobate and lithium borate, and mechanically polishing the piezoelectric substrate and the substrate so as to adjust a thickness of the piezoelectric substrate and the substrate. Since the piezoelectric substrate and the substrate are directly bonded to each other, the piezoelectric filter has remarkably high geometric precision by sufficiently controlling the thickness of the piezoelectric substrate and the substrate and flatness of the piezoelectric substrate and the substrate.

Meanwhile, it is possible to formulate the piezoelectric filter by using a piezoelectric substrate which cannot be formed as a thin film.

Furthermore, by mechanically polishing the piezoelectric substrate bonded to the substrate so as to adjust thickness of the piezoelectric substrate, it becomes possible to adjust frequency of the piezoelectric filter. Therefore, adjustments of central frequency of the piezoelectric filter can be adjusted easily and the piezoelectric filter can be mass produced.

### BRIEF DESCRIPTION OF THE DRAWINGS

This object and features of the present invention will become apparent from the following description taken in conjunction with the preferred embodiments thereof with reference to the accompanying drawings, in which:
Fig. 1 is a perspective view of a piezoelectric filter according to a first embodiment of the present invention;
Fig. 2 is a graph showing characteristics of a quartz piezoelectric filter related to the art of the invention;
Fig. 3 is a perspective view of a variation of the piezoelectric filter of Fig. 1, in which an earth electrode is divided into a pair of earth electrodes;
Fig. 4 is a view showing production steps of the piezoelectric filter of Fig. 1;
Fig. 5 is view showing production steps of a piezoelectric filter which is a first modification of the piezoelectric filter of Fig. 1;
Fig. 6 is a graph showing characteristics of the piezoelectric filter of Fig. 5;
Fig. 7 is a perspective view of a piezoelectric filter which is a second modification of the piezoelectric filter of Fig. 1;
Fig. 8 is a graph showing characteristics of the piezoelectric filter of Fig. 7;
Fig. 9 is a view showing production steps of the piezoelectric filter of Fig. 7;
Fig. 10 is a perspective view of a piezoelectric filter which is a third modification of the piezoelectric filter of Fig. 1;
Fig. 11 is a graph showing characteristics of the piezoelectric filter of Fig. 10;
Fig. 12 is a view showing production steps of the piezoelectric filter of Fig. 10;
Fig. 13 is a perspective view of a piezoelectric filter according to a second embodiment of the present invention;
Fig. 14 is a graph showing characteristics of the piezoelectric filter of Fig. 13;
Fig. 15 is a view showing production steps of the piezoelectric filter of Fig. 13;
Fig. 16 is a perspective view of a piezoelectric filter which is a first modification of the piezoelectric filter of Fig. 13;
Fig. 17 is a graph showing characteristics of the piezoelectric filter of Fig. 16;
Fig. 18 is a view showing production steps of the piezoelectric filter of Fig. 16;
Fig. 19 is a perspective view of a piezoelectric filter which is a second modification of the piezoelectric filter of Fig. 13;
Fig. 20 is a graph showing characteristics of the piezoelectric filter of Fig. 19;
Fig. 21 is a view showing production steps of the piezoelectric filter of Fig. 19;
Fig. 22 is a perspective view of a prior art piezoelectric filter (already referred to); and
Fig. 23 is a front elevational view of another prior art piezoelectric filter (already referred to).

Before the description of the present invention proceeds, it is to be noted that like parts are designated by like reference numerals throughout several views of the accompanying drawings.

### DETAILED DESCRIPTION OF THE INVENTION

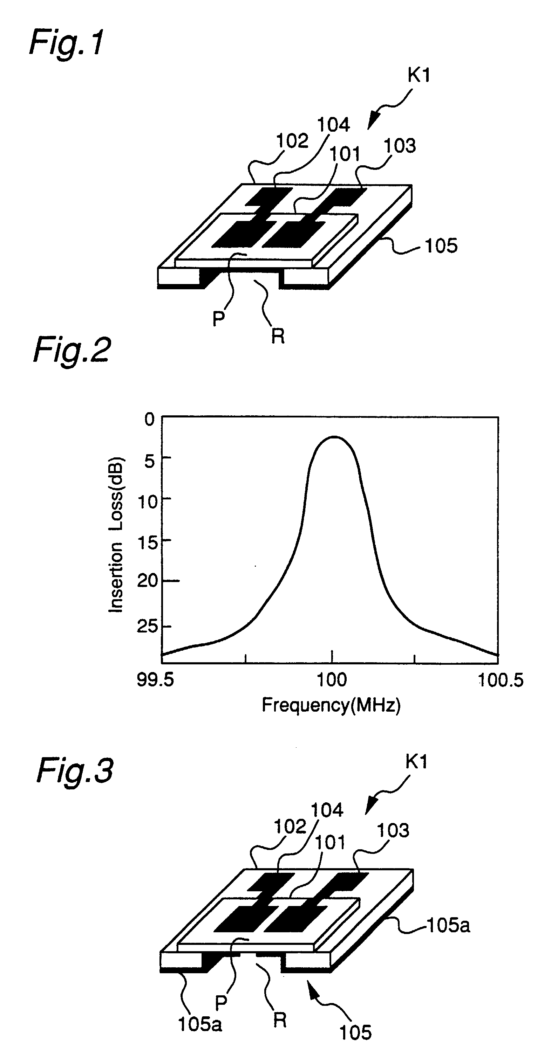

Referring now to the drawings, there is shown in Fig. 1, a piezoelectric filter K1 according to a first embodiment of the present invention. The piezoelectric filter K1 includes an oscillatory substrate 101 acting as a piezoelectric substrate, a glass substrate 102 for holding the substrate 101, an input electrode 103, an output electrode 104 and an earth electrode 105. The substrate 101 is bonded to the glass substrate 102 by direct bonding. The input and output electrodes 103 and 104 are provided on upper faces of the substrate 101 and the glass substrate 102, while the earth electrode 105 is provided on lower faces of the substrate 101 and the glass substrate 102. The glass substrate 102 is formed with a recess R, while the substrate 101 has an oscillatory portion P confronting the recess R.

As shown in Fig. 3, in the piezoelectric filter K1, the earth electrode 105 may also be divided into a plurality of, for example, a pair of earth electrodes 105a.

Furthermore, in this embodiment, the piezoelectric substrate but may be formed from any one of lithium tantalate, lithium niobate and lithium borate.

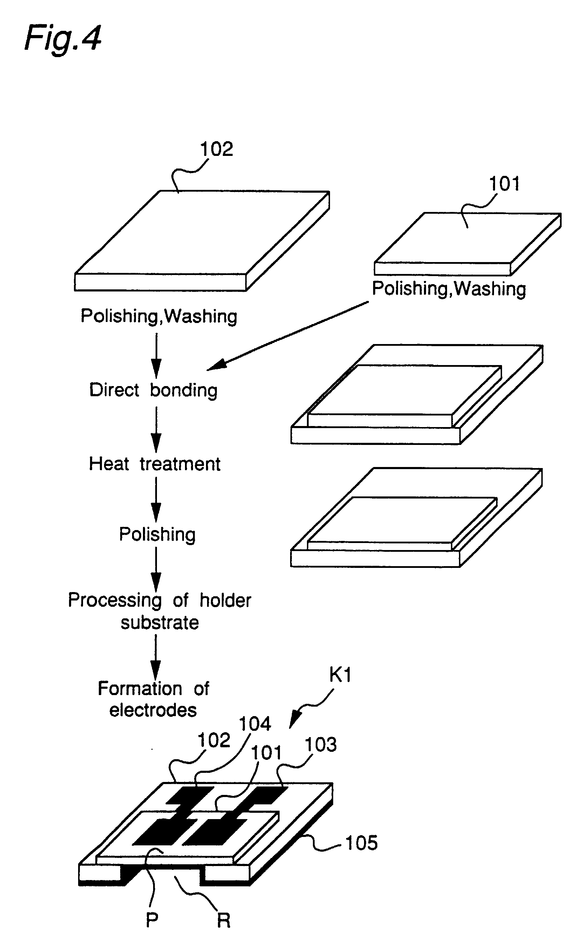

Fig. 4 shows production steps of the piezoelectric filter K1. The substrate 101 and the glass substrate 102 are initially polished and washed. Then, the substrate 101 and the glass substrate 102 are subjected to a hydrophilic treatment by using hydrophilic liquid so as to be bonded to each other by direct bonding. At this time, the substrate 101 and the glass substrate 102 are already bonded to each other. However, since this bonding strength is quite small, the substrate 101 and the glass substrate 102 can be neither secured to each other nor processed. Thus, in order to increase the bonding strength, the substrate 101 and the glass substrate 102 are heat treated at a predetermined temperature which should be lower than a temperature leading to loss of piezoelectric property of the piezoelectric substrate 101 and a softening point of the glass substrate 102. Lithium tantalate loses piezoelectric property at a temperature of about 600 °C, lithium niobate loses piezoelectric property at a temperature of about 1000 °C and lithium borate loses piezoelectric property at a temperature of about 600 °C. On the other hand, glass used for the glass substrate 102 has a softening point of 450 °C. Thus, the predetermined temperature is set at 300 °C. By this heat treatment step, the substrate 101 and the glass substrate 102 are securely bonded to each other without using adhesive. Then, the substrate 101 is polished so as to adjust its thickness. Subsequently, in order to produce the oscillatory portion P of the substrate 101, a portion of the glass substrate 102, which confronts the oscillatory portion P, is removed by etching and thus, the recess R is obtained. Then, the signal electrodes 103 and 104 and the earth electrode 105 are produced by depositing chromium and gold, respectively and photolithography.

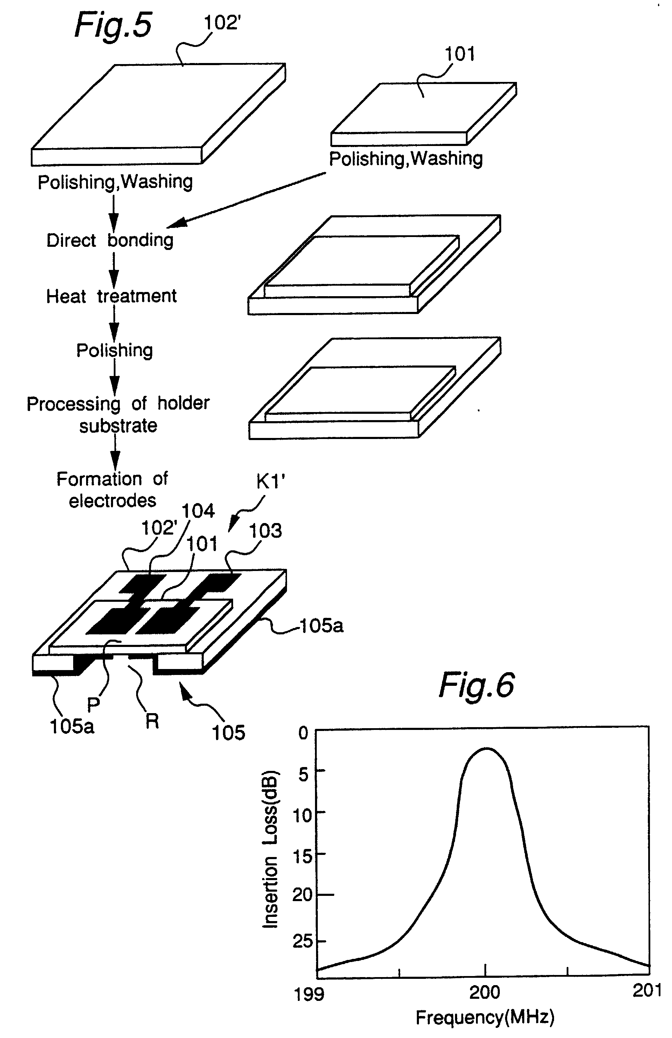

Fig. 5 shows production steps of a piezoelectric filter K1' which is a first modification of the piezoelectric filter K1. The piezoelectric filter K1' includes a glass substrate 102' which is made of glass having a coefficient of thermal expansion substantially identical with that of the substrate 101. Since other constructions of the piezoelectric filter K1' are similar to those of the piezoelectric filter K1, the description is abbreviated for the sake of brevity.

In Fig. 5, the substrate 101 and the glass substrate 102' are initially polished and washed. Then, the substrate 101 and the glass substrate 102' are subjected to a hydrophilic treatment by using hydrophilic liquid so as to be bonded to each other by direct bonding. At this time, the substrate 101 and the glass substrate 102' are already bonded to each other. However, since this bonding strength is quite small, the substrate 101 and the glass substrate 102' can neither be secured to each other nor processed. Thus, in order to increase the bonding strength, the substrate 101 and the glass substrate 102' are heat treated at a temperature of 450 °C. The bonding strength is determined by this heat treatment temperature. As the heat treatment temperature is raised, the bonding strength increases. However, permissible heat treatment temperature is determined by coefficients of thermal expansion of the piezoelectric substrate 101 and glass of the glass substrate 102' and thicknesses of the substrate 101 and the glass substrate 102'. The heat treatment temperature can be raised further as the above coefficients of thermal expansion become smaller and thickness of the substrate 101 becomes smaller relative to that of the glass substrate 102'. By this heat treatment step, the substrate 101 and the glass substrate 102' are securely bonded to each other without using adhesive. Thereafter, in order to put the substrate 101 to high-frequency use, the substrate 101 is polished. Since the heat treatment has been performed at 450 °C, bonding strength between the substrate 101 and the glass substrate 102' is quite large. As a result, the substrate 101 can be polished to a thickness of 8 µm. Subsequently, in order to produce the oscillatory portion P of the substrate 101, a portion of the glass substrate 102, which confronts the oscillatory portion P, is removed by etching and thus, the recess R is obtained. Then, the signal electrodes 103 and 104 and the earth electrode 105 are produced by depositing chromium and gold, respectively and photolithography.

The piezoelectric filter K1' produced as described above has characteristics shown in Fig. 6. As shown in Fig. 6, the piezoelectric filter K1' has a central frequency of 200 MHz, which has been so far difficult to obtain in a known method of producing a piezoelectric filter.

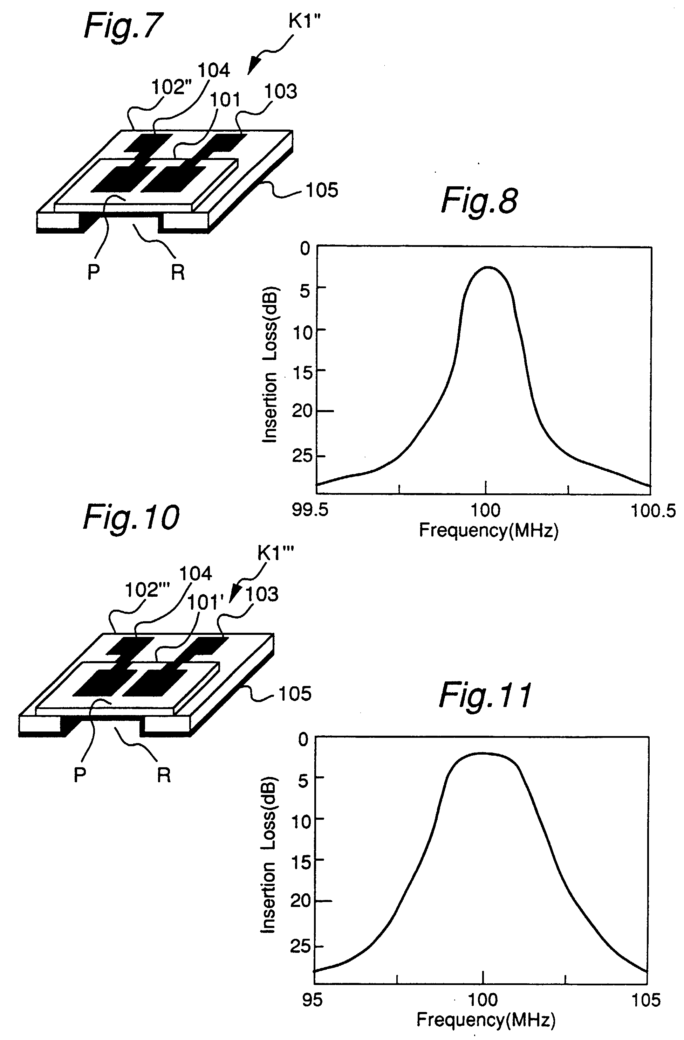

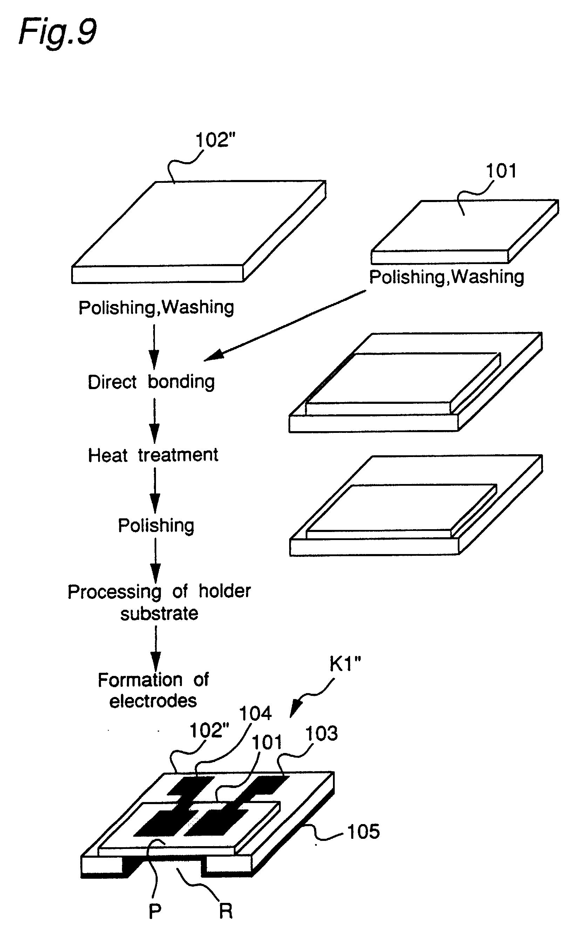

Fig. 7 shows a piezoelectric filter K1'' which is a second modification of the piezoelectric filter K1. In the piezoelectric substrate K1", the glass substrate 102 of the piezoelectric filter K1 is replaced by a silicon substrate 102". Since other constructions of the piezoelectric filter K1'' are similar to those of the piezoelectric filter K1, the description is abbreviated for the sake of brevity.

The piezoelectric substrate K1'' of the above described arrangement has characteristics shown in Fig. 8. As shown in Fig. 8, the piezoelectric filter K1'' has a central frequency of 100 MHz, which has been so far difficult to obtain in a known piezoelectric filter.

Fig. 9 shows production steps of the piezoelectric filter K1". The substrate 101 and the silicon substrate 102" are initially polished and washed. Then, the substrate 101 and the silicon substrate 102" are subjected to a hydrophilic treatment by using hydrophilic liquid so as to be bonded to each other by direct bonding. At this time, the substrate 101 and the silicon substrate 102" are already bonded to each other. However, since this bonding strength is quite small, the substrate 101 and the silicon substrate 102'' can be neither secured to each other nor processed. Thus, in order to increase the bonding strength, the substrate 101 and the silicon substrate 102" are heat treated at a predetermined temperature which should be lower than a temperature leading to loss of piezoelectric property of the piezoelectric substrate 101. Lithium tantalate loses piezoelectric property at a temperature of about 600 °C, lithium niobate loses piezoelectric property at a temperature of about 1000 °C and lithium borate loses piezoelectric property at a temperature of about 600 °C, Thus, the predetermined temperature is set at 300 °C. By this heat treatment step, the substrate 101 and the silicon substrate 102" are securely bonded to each other without using adhesive. Then, the substrate 101 is polished so as to adjust its thickness. Subsequently, in order to produce the oscillatory portion P of the substrate 101, a portion of the silicon substrate 102", which confronts the oscillatory portion P, is removed by etching and thus, the recess R is obtained. Then, the signal electrodes 103 and 104 and the earth electrode 105 are produced by depositing chromium and gold, respectively and photolithography.

Fig. 10 shows a piezoelectric filter K1"' which is a third modification of the piezoelectric filter K1. In the piezoelectric filter K1"', the substrate 101 acting as a piezoelectric substrate and the substrate 102 for holding the substrate 101 in the piezoelectric filter K1 are, respectively, formed by a substrate 101' made of lithium niobate and a substrate 102"' made of lithium tantalate. Since other constructions of the piezoelectric filter K1''' are similar to those of the piezoelectric filter K1, the description is abbreviated for the sake of brevity.

The piezoelectric filter K1''' of the above described arrangement has characteristics shown in Fig. 11. As shown in Fig. 11, the piezoelectric filter K1''' has a central frequency of 100 MHz, which has been so far difficult to obtain in a known piezoelectric filter.

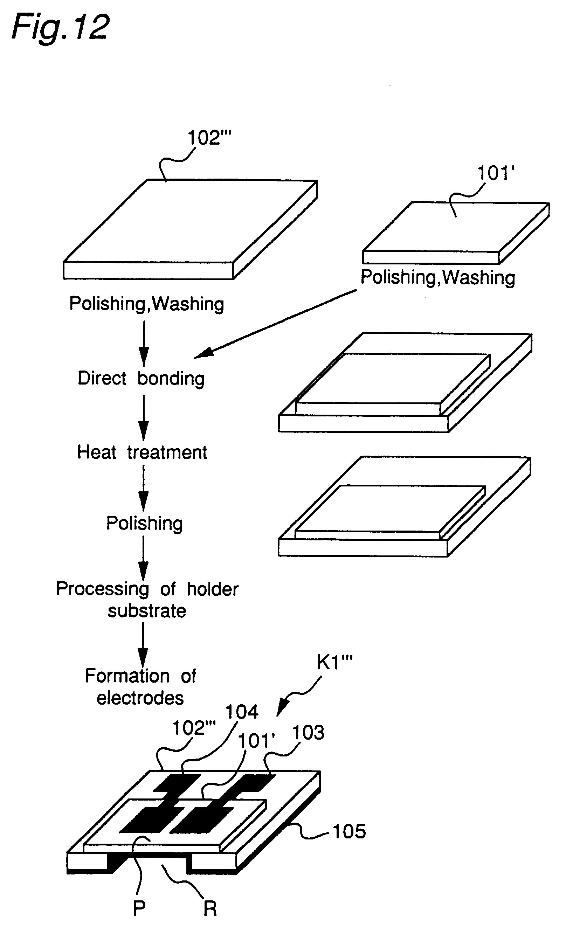

Fig. 12 shows production steps of the piezoelectric filter K1"'. The substrates 101' and 102"' are initially polished and washed. Then, the substrates 101' and 102"' are subjected to a hydrophilic treatment by using hydrophilic liquid so as to be bonded to each other by direct bonding. At this time, the substrates 101' and 102"' are already bonded to each other. However, since this bonding strength is quite small, the substrates 101' and 102"' can be neither secured to each other nor processed. Thus, in order to increase the bonding strength, the substrates 101' and 102''' are heat treated at a predetermined temperature which should be lower than a temperature leading to loss of piezoelectric property of the piezoelectric substrate 101'. Lithium tantalate loses piezoelectric property at a temperature of about 600 °C, lithium niobate loses piezoelectric property at a temperature of about 1000 °C and lithium borate loses piezoelectric property at a temperature of about 600 °C. Thus, the predetermined temperature is set at 300 °C. By this heat treatment step, the substrates 101' and 102''' are securely bonded to each other without using adhesive. Then, the substrate 101' is polished so as to adjust its thickness. Subsequently, in order to produce the oscillatory portion P of the substrate 101', a portion of the substrate 102"', which confronts the oscillatory portion P, is removed by etching and thus, the recess R is obtained. Then, the signal electrodes 103 and 104 and the earth electrode 105 are produced by depositing chromium and gold, respectively and photolithography.

In this modification, combination of lithium niobate and lithium tantalate is described but other combinations can be employed based on principle and functions identical with those of this combination.

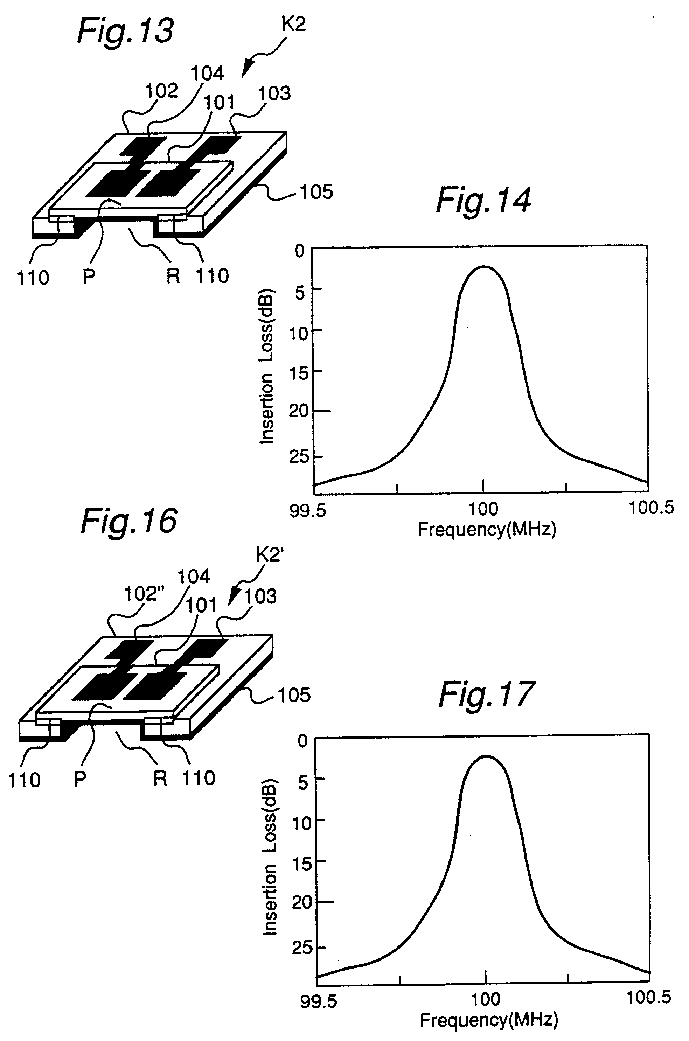

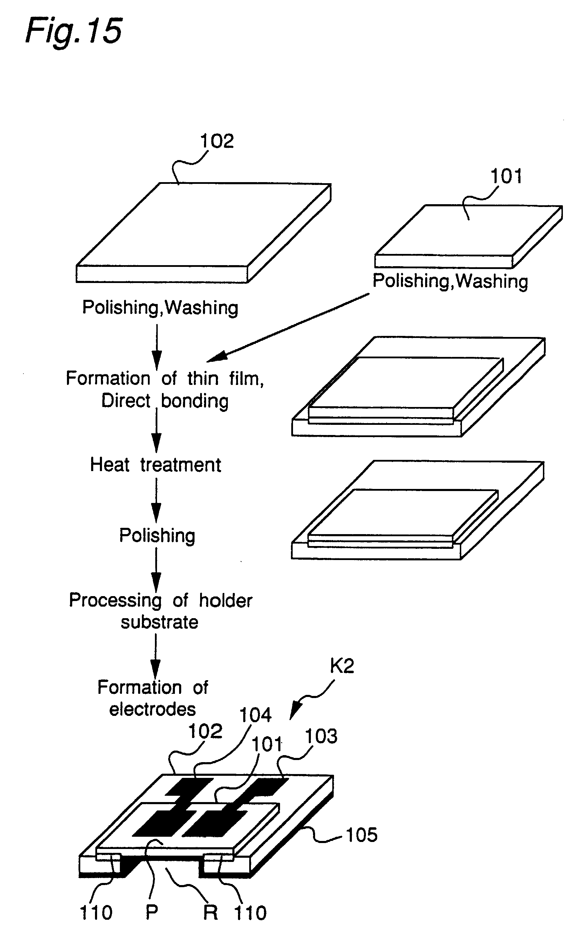

Fig. 13 shows a piezoelectric filter K2 according to a second embodiment of the present invention. In the piezoelectric filter K2, the substrate 101 and the glass substrate 102 for holding the glass substrate 101 are directly bonded to each other by SiO₂ 110 formed on the glass substrate 102. Since other constructions of the piezoelectric filter K2 are similar to those of the piezoelectric filter K1, the description is abbreviated for the sake of brevity.

The piezoelectric filter K2 of the above described arrangement has characteristics shown in Fig. 14. As shown in Fig. 14, the piezoelectric filter K2 has a central frequency of 100 MHz, which has been so far difficult to Fig. 15 shows production steps of the piezoelectric filter K2. Initially, the substrate 101 and the glass substrate 102 are polished and washed. Then, SiO₂ 110 is formed on the glass substrate 102 to a thickness of 1 µm by using CVD method. Then, the substrate 101 and SiO₂ 110 on the glass substrate 102 are subjected to a hydrophilic treatment by using hydrophilic liquid so as to be bonded to each other by direct bonding. At this time, the substrate 101 and the glass substrate 102 are already bonded to each other. However, since this bonding strength is quite small, the substrate 101 and the glass substrate 102 can be neither secured to each other nor processed. Thus, in order to increase the bonding strength, the quartz substrate 101 and the glass substrate 102 are heat treated at a predetermined temperature which should be lower than a temperature leading to loss of piezoelectric property of the piezoelectric substrate 101 and a softening point of the glass substrate 102. Lithium tantalate loses piezoelectric property at a temperature of about 600 °C, lithium niobate loses piezoelectric property at a temperature of about 1000 °C and lithium borate loses piezoelectric property at a temperature of about 600 °C. On the other hand, glass used for the glass substrate 102 has a softening point of 450 °C. Thus, the predetermined temperature is set at 300 °C. By this heat treatment step, the substrate 101 and the glass substrate 102 are securely bonded to each other without using adhesive. Then, the substrate 101 is polished so as to adjust its thickness. Subsequently, in order to produce the oscillatory portion P of the substrate 101, a portion of the glass substrate 102, which confronts the oscillatory portion P, is removed by etching and thus, the recess R is obtained. Then, the signal electrodes 103 and 104 and the earth electrode 105 are produced by depositing chromium and gold, respectively and photolithography.

In this process, SiO₂ 110 is formed as a thin film and thus, is softer than glass of the glass substrate 102 and the substrate 101. Hence, even if minute foreign matter is present at the direct bonding interface between the substrate 101 and the glass substrate 102, SiO₂ 110 absorbs the foreign matter, so that direct bonding between the quartz substrate 101 and the glass substrate 102 is facilitated advantageously. On the contrary, if SiO₂ is not provided at the direct bonding interface, such a case may happen that the substrate 101 and the glass substrate 102 cannot be directly bonded to each other due to minute foreign matter present at the bonding interface. However, in this embodiment, since SiO₂ is present at the bonding interface, the substrate 101 and the glass substrate 102 can be directly bonded to each other even if minute foreign matter exists at the direct bonding interface. As a result, such an effect can be achieved that yield is raised with substantially no change of electrical characteristics.

In this process, the piezoelectric substrate is made of any one of lithium niobate, lithium tantalate and lithium borate. Meanwhile, the substrate for holding is made of glass. However, even if the substrate for holding the substrate (101) is made of any one of silicon, lithium niobate, lithium tantalate and lithium, the same result can be obtained. Furthermore, in this embodiment, SiO₂ is employed as silicon compound present at the direct bonding interface between the quartz substrate and the glass substrate. However, even if SiO₂ is replaced by Si or SiN, the same result can be obtained by achieving effects identical with those of SiO₂. Meanwhile, in this process, CVD method is employed for producing SiO₂ but may be replaced by any other method of formulating a similar film, for example, sputtering method, deposition method, etc. Furthermore, in this process, silicon compound is formed on the glass substrate but may be formed on the piezoelectric substrate so as to achieve the same effects.

Fig. 16 shows a piezoelectric filter K2' which is a first modification of the piezoelectric filter K2. In the piezoelectric filter K2', the glass substrate 102 of the piezoelectric filter K2 is replaced by the silicon substrate 102". Since other constructions of the piezoelectric filter K2' is similar to those of the piezoelectric filter K2, the description is abbreviated for the sake of brevity.

The piezoelectric filter K2' of the above described arrangement has characteristics shown in Fig. 17. As shown in Fig. 17, the piezoelectric filter K2' has a central frequency of 100 MHz, which has been so far difficult to obtain in a known piezoelectric filter.

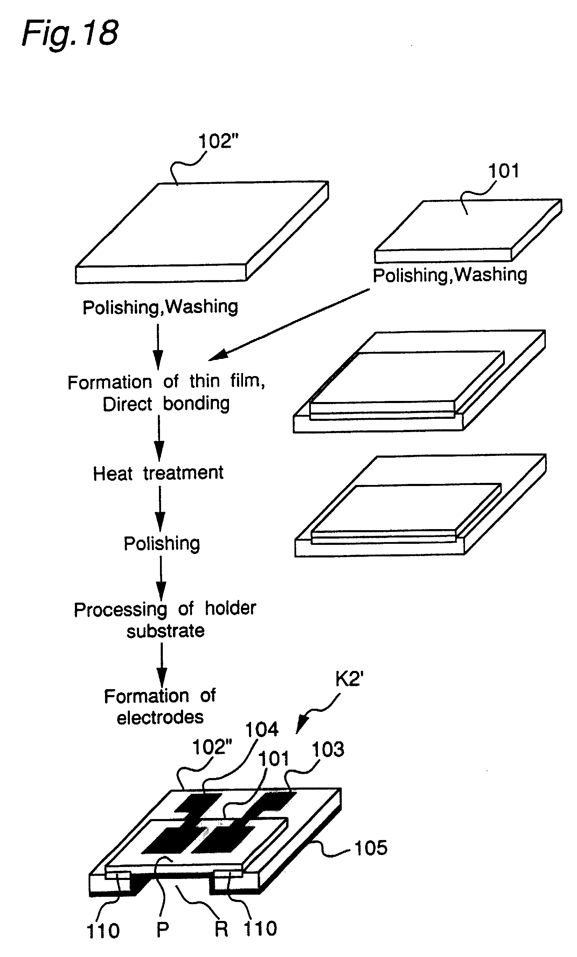

Fig. 18 shows production steps of the piezoelectric filter K2'. The substrate 101 and the silicon substrate 102" are initially polished and washed. SiO₂ 110 is formed on the silicon substrate 102" to a thickness of 1µm by using CVD method. Then, the substrate 101 and SiO₂ 110 on the silicon substrate 102" are subjected to a hydrophilic treatment by using hydrophilic liquid so as to be bonded to each other by direct bonding. At this time, the substrate 101 and the silicon substrate 102" are already bonded to each other. However, since this bonding strength is quite small, the substrate 101 and the silicon substrate 102" can be neither secured to each other nor processed. Thus, in order to increase the bonding strength, the substrate 101 and the silicon substrate 102" are heat treated at a predetermined temperature which should be lower than a temperature leading to loss of piezoelectric property of the piezoelectric substrate 101. Lithium tantalate loses piezoelectric property at a temperature of about 600 °C, lithium niobate loses piezoelectric property at a temperature of about 1000 °C and lithium borate loses piezoelectric property at a temperature of about 600 °C. Thus, the predetermined temperature is set at 300 °C. By this heat treatment step, the substrate 101 and the silicon substrate 102" are securely bonded to each other without using adhesive. Then, the substrate 101 is polished so as to adjust its thickness. Subsequently, in order to produce the oscillatory portion P of the substrate 101, a portion of the silicon substrate 102", which confronts the oscillatory portion P, is removed by etching and thus, the recess R is obtained. Then, the signal electrodes 103 and 104 and the earth electrode 105 are produced by depositing chromium and gold, respectively and photolithography.

In the piezoelectric filter K2' produced as described above, the same effects as those of the piezoelectric filter K2 can be obtained.

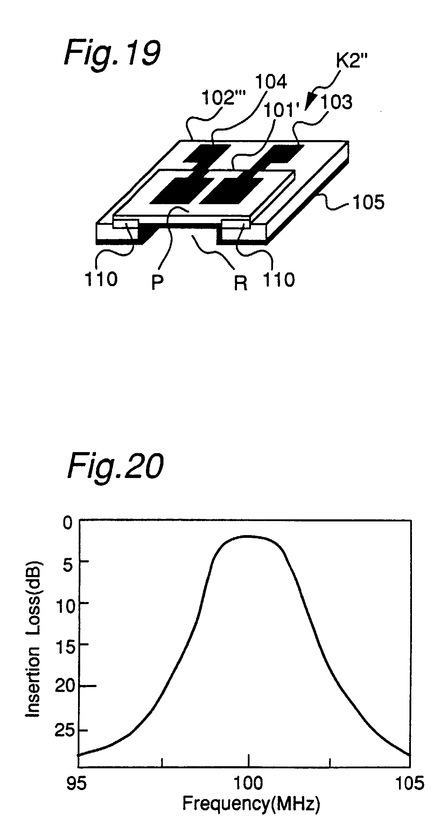

Fig. 19 shows a piezoelectric filter K2'' which is a second modification of the piezoelectric filter K2. In the piezoelectric filter K2", the substrate 101 and the substrate 102 of the piezoelectric filter K2 are formed by the substrate 101' made of lithium niobate and the substrate 102"' made of lithium tantalate, respectively. Since other constructions of the piezoelectric filter K2'' are similar to those of the piezoelectric filter K2, the description is abbreviated for the sake of brevity.

The piezoelectric filter K2'' has characteristics shown in Fig. 20. As shown in Fig. 20, the piezoelectric filter K2'' has a central frequency of 100 MHz, which has been so far difficult to obtain in a known piezoelectric device.

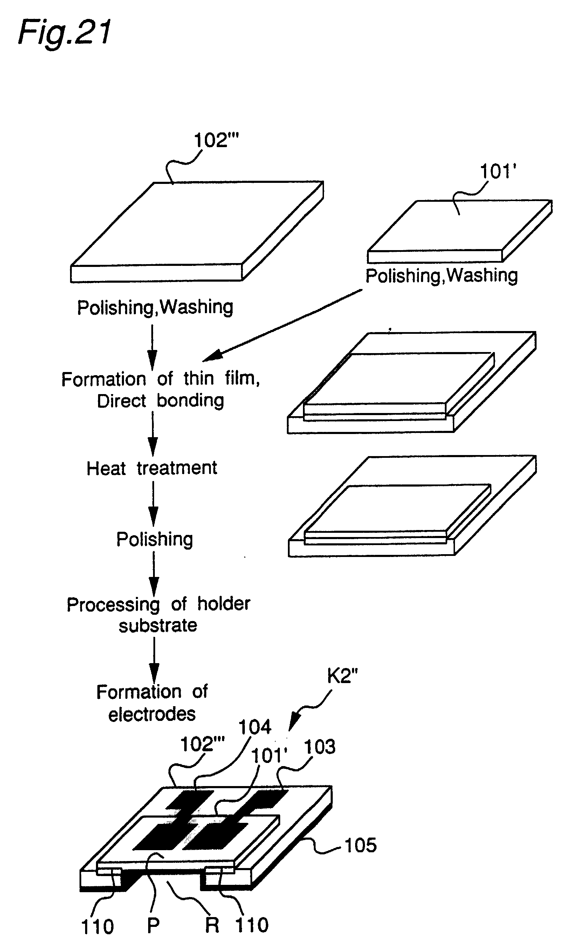

Fig. 21 shows production steps of the piezoelectric filter K2". The substrates 101' and 102''' are initially polished and washed. SiO₂ 110 is formed on the substrate 102"' to a thickness of 1µm by using CVD method. Then, the substrate 101' and SiO₂ 110 on the substrate 102"' are subjected to a hydrophilic treatment by using hydrophilic liquid so as to be bonded to each other by direct bonding. At this time, the substrates 101' and 102"' are already bonded to each other. However, since this bonding strength is quite small, the substrates 101' and 102"' can be neither secured to each other nor processed. Thus, in order to increase the bonding strength, the substrates 101' and 102"' are heat treated at a predetermined temperature which should be lower than a temperature leading to loss of piezoelectric property of the piezoelectric substrate 101'. Lithium tantalate loses piezoelectric property at a temperature of about 600 °C, lithium niobate loses piezoelectric property at a temperature of about 1000 °C and lithium borate loses piezoelectric property at a temperature of about 600 °C. Thus, the predetermined temperature is set at 300 °C. By this heat treatment step, the substrates 101' and 102"' are securely bonded to each other without using adhesive. Then, the substrate 101' is polished so as to adjust its thickness. Subsequently, in order to produce the oscillatory portion P of the substrate 101', a portion of the substrate 102"', which confronts the oscillatory portion P, is removed by etching and thus, the recess R is obtained. Then, the signal electrodes 103 and 104 and the earth electrode 105 are produced by depositing chromium and gold, respectively and photolithography.

In the piezoelectric filter K2" produced as described above, the same effects as those of the piezoelectric filter K2 can be achieved.

## Claims

1. A method for manufacturing a piezoelectric filter,
comprising the steps of:
a) subjecting surfaces of an oscillatory plate (101) and a substrate plate (102; 102") for holding the plate (101) to a hydrophilic treatment; the plate (101) being made of one of lithium tantalate, lithium niobate and lithium borate; the substrate plate (102; 102") for holding the plate (101) being made of one of quartz (SiO2), lithium tantalate, lithium niobate and lithium borate, glass or silicon;
b) bringing the surfaces of the plate (101) and the substrate plate (102; 102") for holding the plate (101) into contact with each other; and
c) subjecting the plate (101) and the substrate plate (102; 102") for holding the plate (101) to a heat treatment at a predetermined temperature such that the piezoelectric plate (101) and the substrate plate (102; 102") for holding the piezoelectric plate (101) are directly bonded to each other; the predetermined temperature being lower than a temperature leading to a loss of the piezoelectric property by the plate (101) even after the heat treatment.

2. The method of producing a piezoelectric filter according to claim 1, characterized in that the method contains the additional step of
a') providing silicon or silicon compound (110) on one of the opposed surfaces of said oscillatory plate (101) and said plate for holding the plate (101) prior to step a).

3. The method of producing a piezoelectric filter according to one of claims 1 and 2,
characterized by the step of
d) polishing and washing said oscillatory plate (101) and said plate for holding the plate (101) at an initial stage.

4. A method for manufacturing a piezoelectric filter according to one of claims 1 to 3,
characterized in that said plate (101) is a piezoelectric plate.

5. A piezoelectric filter comprising:
a) an oscillatory plate (101) which has an oscillatory portion;
b) a substrate plate (102; 102") for holding the plate (101), to which the plate (101) is bonded; and
c) first and second oscillatory electrode members (103, 104, 105) which are provided on opposite faces of the oscillatory portion, respectively, such that at least one of the first and second oscillatory electrode members (103, 104, 105) is divided into a plurality of counter electrodes;
characterized in that
d) said oscillatory plate (101) is made of lithium tantalate, lithium niobate or lithium borate;
e) said substrate plate (102; 102") for holding the plate (101) is made of lithium tantalate, lithium niobate, lithium borate, glass or silicon; and
f) said oscillatory plate (101) is directly bonded to said substrate plate (102; 102") for holding the plate (101) according to the method of one of claims 1 to 3.

6. A piezoelectric filter as claimed in claim 5,
wherein the substrate plate (102; 102") for holding the plate (101) is a glass plate (102) made of glass having a coefficient of thermal expansion substantially identical with that of material of the plate (101).

7. A piezoelectric filter according to claim 5 or 6,
characterized in that there is a very thin layer of silicon or silicon compound (110) between the plate (101) and said substrate plate (102; 102") for holding the plate (101).

8. A piezoelectric filter according to one of claims 5 to 7,
characterized in that said plate (101) is a piezoelectric plate.

## Patentansprüche

1. Verfahren zur Herstellung eines piezoelektrischen Filters, mit den Schritten:
a) Oberflächen einer oszillatorischen Platte (101) und einer Substratplatte (102; 102") zum Halten der Platte (101) werden einer hydrophilen Behandlung ausgesetzt; wobei die Platte (101) aus Lithiumtantalat, Lithiumniobat oder Lithiumborat hergestellt ist; wobei die Substratplatte (102; 102") zum Halten der Platte (101) aus Quarz (Si02), Lithiumtantalat, Lithiumniobat, Lithiumborat, Glas oder Silizium hergestellt ist;
b) die Oberflächen der Platte (101) und der Substratplatte (102; 102") zum Halten der Platte (101) werden in Kontakt miteinander gebracht; und
c) die Platte (101) und die Substratplatte (102; 102") zum Halten der Platte (101) werden derart einer Hitzebehandlung bei einer vorbestimmten Temperatur ausgesetzt, daß die piezoelektrische Platte (101) und die Substratplatte (102; 102") zum Halten der piezoelektrischen Platte (101) direkt miteinander verbunden werden; wobei die vorbestimmte Temperatur niedriger ist als eine Temperatur, die zu einem Verlust der piezoelektrischen Eigenschaft der Platte (101), auch nach der Hitzebehandlung, führt.

2. Verfahren zur Herstellung eines piezoelektrischen Filters nach Anspruch 1,
dadurch gekennzeichnet, daß das Verfahren den zusätzlichen Schritt enthält:
a') Silizium oder Siliziumverbindung (110) wird auf einer der gegenüberliegenden Oberflächen der oszillatorischen Platte (101) und der Platte zum Halten der Platte (101) vor dem Schritt a) zur Verfügung gestellt.

3. Verfahren zur Herstellung eines piezoelektrischen Filters nach einem der Ansprüche 1 und 2,
gekennzeichnet durch den Schritt:
d) Die schwingende Platte (101) und die Platte zum Halten der Platte (101) werden in einer Anfangsstufe poliert und gewaschen.

4. Verfahren zur Herstellung eines piezoelektrischen Filters nach einem der Ansprüche 1 bis 3,
dadurch gekennzeichnet, daß die Platte (101) eine piezoelektrische Platte ist.

5. Piezoelektrischer Filter mit:
a) einer oszillatorischen Platte (101), welche einen oszillatorischen Abschnitt aufweist;
b) einer Substratplatte (102; 102") mit welcher die Platte (101) verbunden ist, zum Halten der Platte (101); und
c) erste und zweite oszillatorische Elektrodenglieder (103, 104, 105), die jeweils auf gegenüberliegenden Seiten des oszillatorischen Abschnittes angeordnet sind, derart, daß mindestens eines der ersten und zweiten oszillatorischen Elektrodenglieder (103, 104, 105) in eine Vielzahl von Gegenelektroden aufgeteilt ist;
dadurch gekennzeichnet, daß
d) die oszillatorische Platte (101) aus Lithiumtantalat, Lithiumniobat oder Lithiumborat hergestellt ist;
e) die Substratplatte (102; 102") zum Halten der Platte (101) aus Lithiumtantalat, Lithiumniobat, Lithiumborat, Glas oder Silikon hergestellt ist und
f) die oszillatorische Platte (101) direkt mit der Substratplatte (102, 102") zum Halten der Platte (101) verbunden ist, gemäß dem Verfahren nach einem der Ansprüche 1 bis 3.

6. Piezoelektrischer Filter nach Anspruch 5, wobei die Substratplatte (102; 102") zum Halten der Platte (101) eine Glasplatte (102) ist, die aus Glas gefertigt ist, welches einen thermischen Ausdehnungskoeffizienten aufweist, welcher im wesentlichen identisch mit dem des Materials der Platte (101) ist.

7. Piezoelektrischer Filter nach einem der Ansprüche 5 oder 6,
dadurch gekennzeichnet, daß sich eine sehr dünne Schicht aus Silizium oder Siliziumverbindung (110) zwischen der Platte (101) und der Substratplatte (102, 102") zum Halten der Platte (101) befindet.

8. Piezoelektrischer Filter nach einem der Ansprüche 5 bis 7,
dadurch gekennzeichnet, daß die Platte (101) eine piezoelektrische Platte ist.

## Revendications

1. Procédé de fabrication d'un filtre piézo-électrique,
comprenant les étapes consistant à :
a) soumettre les surfaces d'une plaque oscillante (101) et d'une plaque de substrat (102 ; 102") destinée à maintenir la plaque (101) à un traitement hydrophile, la plaque (101) étant faite d'un élément parmi le tantalate de lithium, le niobate de lithium et le borate de lithium, la plaque de substrat (102 ; 102") destinée à maintenir la plaque (101) étant faite d'un élément parmi le quartz (SiO₂), le tantalate de lithium, le niobate de lithium et le borate de lithium, le verre ou le silicium,
b) amener les surfaces de la plaque (101) et de la plaque de substrat (102 ; 102") destinée à maintenir la plaque (101) jusqu'en contact l'une avec l'autre, et
c) soumettre la plaque (101) et la plaque de substrat (102 ; 102") destinée à maintenir la plaque (101) à un traitement thermique à une température prédéterminée de façon à ce que la plaque piézo-électrique (101) et la plaque de substrat (102 ; 102") destinée à maintenir la plaque piézo-électrique (101) soient collées par liaison directe l'une à l'autre, la température prédéterminée étant inférieure à une température conduisant à une perte de la propriété piézo-électrique de la plaque (101), même après le traitement thermique.

2. Procédé de fabrication d'un filtre piézo-électrique selon la revendication 1, caractérisé en ce que le procédé comprend l'étape supplémentaire consistant à
a') disposer du silicium ou un composé de silicium (110) sur l'une des surfaces opposées de ladite plaque oscillante (l01) et de ladite plaque destinée à maintenir la plaque (101) avant l'étape a).

3. Procédé de fabrication d'un filtre piézo-électrique selon l'une quelconque des revendications 1 et 2,
caractérisé par l'étape consistant à
d) polir et laver ladite plaque oscillante (101) et ladite plaque destinée à maintenir la plaque (101) à un stade initial.

4. Procédé de fabrication d'un filtre piézo-électrique selon l'une quelconque des revendications 1 à 3,
caractérisé en ce que ladite plaque (101) est une plaque piézo-électrique.

5. Filtre piézo-électrique comprenant :
a) une plaque oscillante (101) qui comporte une partie oscillante,
b) une plaque de substrat (102 ; 102") destinée à maintenir la plaque (101), sur laquelle est collée la plaque (101), et
c) des premier et second éléments d'électrodes oscillantes (103, 104, 105) qui sont disposés sur des faces opposées de la partie oscillante, respectivement, de façon à ce qu'au moins l'un des premier et second éléments d'électrodes oscillantes (103, 104, 105) soient divisés en une pluralité de contre-électrodes,
caractérisé en ce que
d) ladite plaque oscillante (101) est faite de tantalate de lithium, de niobate de lithium, ou de borate de lithium,
e) ladite plaque de substrat (102 ; 102") destinée à maintenir la plaque (101) est faite de tantalate de lithium, de niobate de lithium, de borate de lithium, de verre ou de silicium,
f) ladite plaque oscillante (101) est collée directement sur ladite plaque de substrat (102 ; 102") destinée à maintenir la plaque (101) conformément au procédé selon l'une quelconque des revendications 1 à 3.

6. Filtre piézo-électrique selon la revendication 5,
dans lequel la plaque de substrat (102 ; 102") destinée à maintenir la plaque (101) est une plaque de verre (102) faite d'un verre présentant un coefficient de dilatation thermique pratiquement identique à celui du matériau de la plaque (101).

7. Filtre piézo-électrique selon la revendication 5 ou 6,
caractérisé en ce qu'il existe une très mince couche de silicium ou de composé de silicium (110) entre la plaque (101) et ladite plaque de substrat (102 ; 102") destinée à maintenir la plaque (101).

8. Filtre piézo-électrique selon l'une quelconque des revendications 5 à 7,
caractérisé en ce que ladite plaque (101) est une plaque piézo-électrique.
